Europäisches Patentamt

European Patent Office

Office européen des brevets

(11) Publication number: **0 268 859**
**A2**

## EUROPEAN PATENT APPLICATION

(21) Application number: 87115785.5

(22) Date of filing: 27.10.87

(51) Int. Cl.⁴: **H01L 21/48** , **H01L 21/78**

The title of the invention has been amended (Guidelines for Examination in the EPO, A-III, 7.3).

(30) Priority: 27.10.86 JP 253865/86

(43) Date of publication of application:
**01.06.88 Bulletin 88/22**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Tokioka, Fumio c/o Patent Division**
**Kabushiki Kaisha Toshiba 1-1 Shibaura**
**1-chome**
**Minato-ku Tokyo 105(JP)**
Inventor: **Iwanishi, Masaaki c/o Patent**
**Division**
**Kabushiki Kaisha Toshiba 1-1 Shibaura**
**1-chome**
**Minato-ku Tokyo 105(JP)**
Inventor: **Tani, Keizo c/o Patent Division**
**Kabushiki Kaisha Toshiba 1-1 Shibaura**
**1-chome**
**Minato-ku Tokyo 105(JP)**
Inventor: **Nakao, Junichi c/o Patent Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Method of dividing semiconductor wafers.

(57) A method for manufacturing a semiconductor device includes a step of forming a plurality of semiconductor pellets in substantially a matrix form in a semiconductor wafer (13) and processing the same. A group of large-sized semiconductor pellets (12) are formed in a matrix form in the central area of a semiconductor wafer (13) and a group of small-sized semiconductor pellets (14) are formed in an area between the periphery of the semiconductor wafer (13) and the group of large-sized semiconductor pellets (12) which is not used in the prior art, thus forming the semiconductor pellets (12 and 14) of different sizes in the semiconductor wafer (13). First, a dicing operation is effected to separate the large-sized semiconductor pellets (12) from the small-sized semiconductor pellets (14) and then each group of the large-and small-sized semiconductor pellets (12 and 14) is diced into individual semiconductor pellets.

FIG. 2

## Method for manufacturing a semiconductor device

This invention relates to a method for manufacturing a semiconductor device, and more particularly to the arrangement of pellets formed in a semiconductor wafer.

In general, a semiconductor pellet is formed in a square or rectangular plate form with a thickness of 0.1 to 0.5 mm. Various kinds of semiconductor pellets are provided and are changed in size and shape according to the types of semiconductor elements such as IC and LSI formed in the pellets. Conventionally, in manufacturing semiconductor elements, the same type of semiconductor pellets are formed in a matrix form on a semiconductor wafer. In the process of forming the semiconductor pellets, oxidation step, photo-etching step, impurity diffusion step, heat-treatment step and the like are repeatedly performed. Pellets having semiconductor elements formed therein are subjected to function test or probe test, and good pellets are separated from defective pellets by marking the defective pellets based on the result of the test. Then, the semiconductor wafer is diced or cut apart along dicing lines indicating the boundaries between the semiconductor pellets by, for example, a blade dicer, thereby making a plurality of diced pellets. Thus, a plurality of semiconductor pellets can be obtained from a single wafer.

However, in the case where the same type of semiconductor pellets are formed in the matrix form in the semiconductor wafer as described above, those of the semiconductor pellets located in the peripheral portion of the semiconductor wafer may not be formed in a full square or may have a part cut-away. Thus, semiconductor pellets having a proper function may not be obtained from the peripheral portion of the wafer. That is, only the central portion of the wafer can be effectively used and the peripheral portion cannot be effectively used to form normal semiconductor pellets.

In recent years, various requirements are made in the semiconductor market. For example, semiconductor elements used in an electric power converter circuit are required to operate in a large current (100 to 200 A) at a high voltage (800 to 1500 V). To meet the requirements, the semiconductor pellets are made progressively large and some are made as large as 10 x 10 mm$^2$ to 20 x 20 mm$^2$. Therefore, in the prior art method for manufacturing a semiconductor device in which the same type of semiconductor pellets are formed in a single semiconductor wafer, the area of the peripheral portion of the wafer which cannot be effectively used increases as the size of the semiconductor pellet becomes large.

An object of this invention is to provide a method for manufacturing a semiconductor device in which substantially the entire portion of a semiconductor wafer can be effectively used by making effective use of the peripheral portion of the wafer.

The object of this invention can be attained by a method for manufacturing a semiconductor device comprising a wafer processing step of forming large-sized semiconductor pellets in a matrix form in the central area of a semiconductor wafer and forming small-sized semiconductor pellets outside the central area and in the peripheral portion of the semiconductor wafer, thus forming the semiconductor pellets of different sizes in the semiconductor wafer, and a wafer dividing step of dividing the large-sized semiconductor pellets into individual semiconductor pellets and the small-sized semiconductor pellets into individual semiconductor pellets.

With this construction, since the peripheral portion of the semiconductor wafer which has not been effectively used can be used to form semiconductor pellets, substantially the entire portion of the semiconductor wafer can be effectively used.

This invention can be more fully understood from the following detailed description when taken in conjunction with the accompanying drawings, in which:

Fig. 1 shows a glass mask used in a method for manufacturing a semiconductor device according to one embodiment of this invention;

Fig. 2 shows a pellet pattern formed on a semiconductor wafer using the glass mask of Fig. 1;

Fig. 3 is a diagram illustrating a step of dicing large-sized semiconductor pellets in the central area of the semiconductor wafer of Fig. 2;

Fig. 4 is a diagram illustrating a step of dicing small-sized semiconductor pellets in the peripheral area of the semiconductor wafer of Fig. 2;

Fig. 5 shows a glass mask used in a method for manufacturing a semiconductor device according to another embodiment of this invention;

Fig. 6 shows a pellet pattern formed on a semiconductor wafer using the glass mask of Fig. 5;

Fig. 7 is a diagram illustrating a step of dicing large-sized semiconductor pellets in the central area of the semiconductor wafer of Fig. 6;

Fig. 8 shows a glass mask used in a method for manufacturing a semiconductor device according to still another embodiment of this invention; and

Fig. 9 shows a pellet pattern formed on a semiconductor wafer using the glass mask of Fig. 8.

There will now be described an embodiment of this invention with reference to the drawing by taking a method for manufacturing power transistors (bipolar transistors) as an example. First, a silicon wafer with a diameter of, for example, 125 mm used as a substrate is prepared. The silicon wafer is set in a diffusion furnace and then subjected to oxidation process by passing steam through the furnace to thereby form a silicon oxide film on the surface.

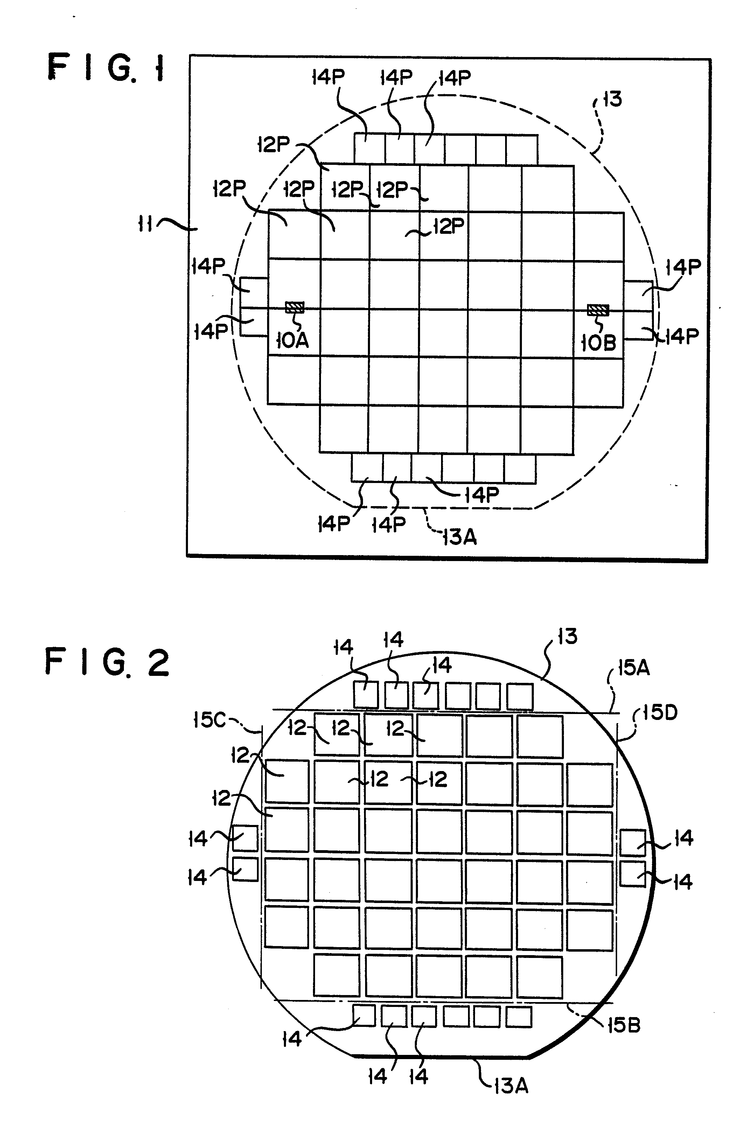

The silicon wafer is selectively etched in a photo-etching process to remove that part of the silicon oxide film which corresponds to base formation regions. Fig. 1 shows a glass mask for element formation used in the photo-etching process. As is clearly shown in Fig. 1, patterns 12P for forming large-sized semiconductor pellets used as high-power transistors are arranged in a matrix form in the central area of glass mask 11. Patterns 12P are so formed that the outermost pellets will not contact with the outer periphery of the silicon wafer. In order to clearly show the positional relationship between the pellet pattern of glass mask 11 and the silicon wafer, the outer periphery of silicon wafer 13 is indicated by broken lines in Fig. 1. Linear portion 13A of silicon wafer 13 indicates the orientation flat portion. Target patterns 10A and 10B for mask alignment are formed on a central one of dicing lines between large-sized semiconductor pellet patterns 12P. Further, patterns 14P for forming small-sized semiconductor pellets used as low-power transistors are formed in an area between large-sized semiconductor pellet patterns 12P and the outer periphery of silicon wafer 13.

After the photo-etching process using glass mask 11, impurity diffusion process of diffusing impurities of a conductivity type opposite to that of the silicon wafer is effected to form base regions with the patterned silicon oxide film as a mask. Subsequently, another photo-etching process is effected to form a mask such as silicon oxide film, photoresist or the like which is used to form emitter regions. Similar to the glass mask shown in Fig. 1, a glass mask used for forming the mask has pellet patterns for forming large-sized semiconductor pellets in the central area and pellet patterns for forming small-sized semiconductor pellets in the peripheral area.

Then, conductive material such as aluminum is deposited on the entire surface of the silicon wafer and patterned to form collector, base and emitter electrodes on the collector, base and emitter regions, respectively.

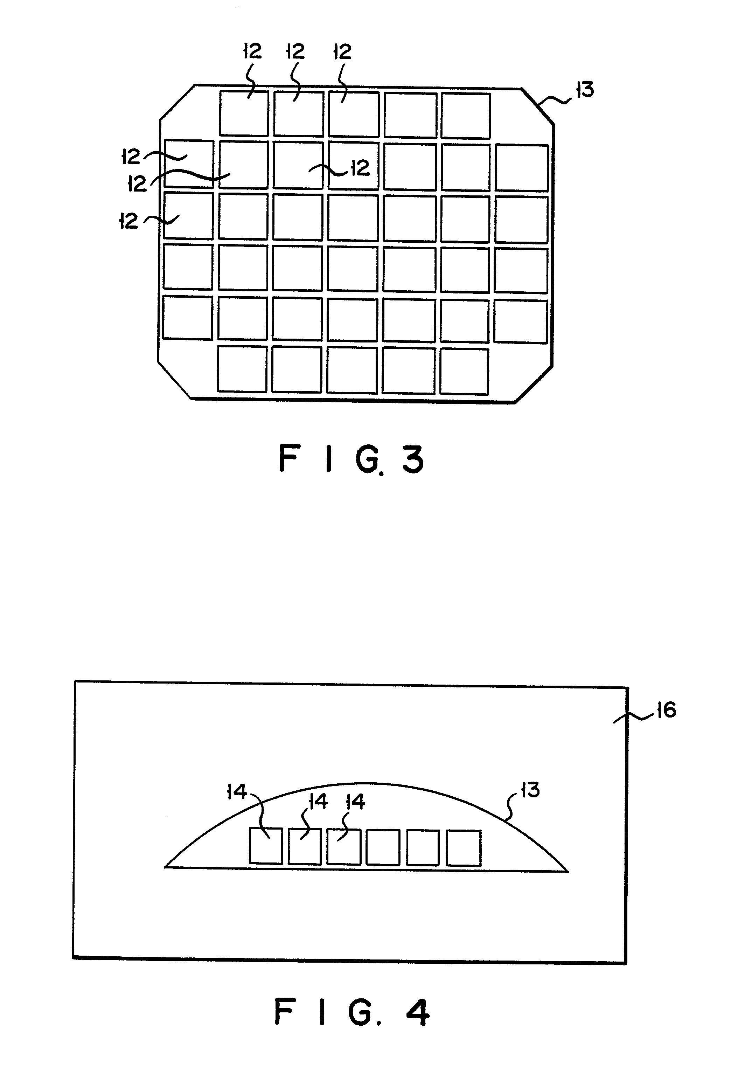

Fig. 2 shows silicon wafer 13 having semiconductor elements thus formed therein. Silicon wafer 13 having semiconductor elements formed therein diced into individual pellets 12 and 14. In order to dice silicon wafer 13 without damaging large-sized semiconductor pellets 12 and small-sized semiconductor pellets 14, semiconductor pellets 12 and 14 are so arranged that at least one of the dicing lines for semiconductor pellets 12 can also be used as that for semiconductor pellets 14. For example, in Fig. 2, dicing lines 15A, 15B, 15C and 15D are commonly used for dicing large-sized semiconductor pellets 12 and small-sized semiconductor pellets 14. That is, the dicing process is effected by first dicing silicon wafer 13 along dicing lines 15A, 15B, 15C and 15D. After the first dicing process, only large-sized semiconductor pellets 12 are left in the central area as shown in Fig. 3. Then, the pattern structure shown in Fig. 3 is diced along dicing lines extending in horizontal and vertical directions between semiconductor pellets 12 and divided into individual large-sized semiconductor pellets 12. Large-sized semiconductor pellets 12 are formed to have an area of, for example, 16.5 x 16.5 mm², 13.0 x 13.0 mm² or 11.0 x 11.0 mm², and an operation current of the power transistor formed in each pellet 12 ranges from 50 A to 100 A.

Next, the peripheral portion of silicon wafer 13 is diced to divide small-sized semiconductor pellets 14 from one another. In this case, the peripheral portion obtained by dicing the silicon wafer along dicing line 15A, 15B, 15C or 15D as shown in Fig. 2 cannot be diced with a blade dicer as it is, because the peripheral portion noted above has an area too small to be fixed to the X-Y stage of a blade dicer by vacuum suction. Therefore, it is necessary to thermally attach the diced peripheral portion to dicer cutting tape 16 as shown in Fig. 4. In this case, dicer cutting tape 16 is vacuum-sucked so as to be fixed to the X-Y stage, and then the peripheral portion of silicon wafer 13 can be diced into individual small-sized semiconductor pellets 14. Small-sized semiconductor pellets 14 are formed to have an area of, for example, 8.0 x 8.0 mm². 7.0 x 7.0 mm² or 6.0 x 6.0 mm², and an operation current of the power transistor formed in each small-sized semiconductor pellet 14 ranges from 15 to 30 A.

Then, semiconductor pellets 12 and 14 are divided into groups according to the size and placed on respective chip trays. The semiconductor pellets placed on the chip tray are subjected to the function test and determined whether they are good or defective.

As described above, two types of semiconductor pellets different in size from each other can be obtained from a single semiconductor wafer. According to such a manufacturing method, the large-sized semiconductor pellets are arranged in a matrix form in the central area of the silicon wafer and the small-sized semiconductor pellets are arranged in an area between the large-sized semiconductor pellets and the periphery of the silicon wafer which was not used effectively in the prior art, so that the entire portion of the silicon wafer can be effectively used. Further, if a semiconductor wafer is used to obtain large-and small-sized semiconductor pellets which can be formed using at least some common manufacturing steps, the manufacturing process will not be complicated simply because two different types of semiconductor pellets are formed from a single silicon wafer.

In recent years, the size of semiconductor pellets has been increased to attain a large operation current and high operation voltage, and thus the pellet size is propressively increased. This invention can be more effective as the size of the semiconductor pellets or semiconductor elements and the diameter of the silicon wafer becomes large.

In the above embodiment, semiconductor elements in the large-sized semiconductor pellets are formed as large power transistors, and semiconductor elements in the small-sized semiconductor pellets are formed as small power transistors. However, this invention is not limited to this embodiment. For example, semiconductor memory devices of large and small capacities can be formed. It is preferable to form large-and small-sized semiconductor pellets which can be manufactured by the same manufacturing method or by using at least some common manufacturing steps. In the case where the manufacturing processes for forming the large-and small-sized semiconductor pellets include different manufacturing steps, a mask is formed to cover the entire surface of the large-or small-sized semiconductor pellets and the different manufacturing step for the small-or large-sized semiconductor pellets is effected so that the different manufacturing steps can be effected without affecting each other.

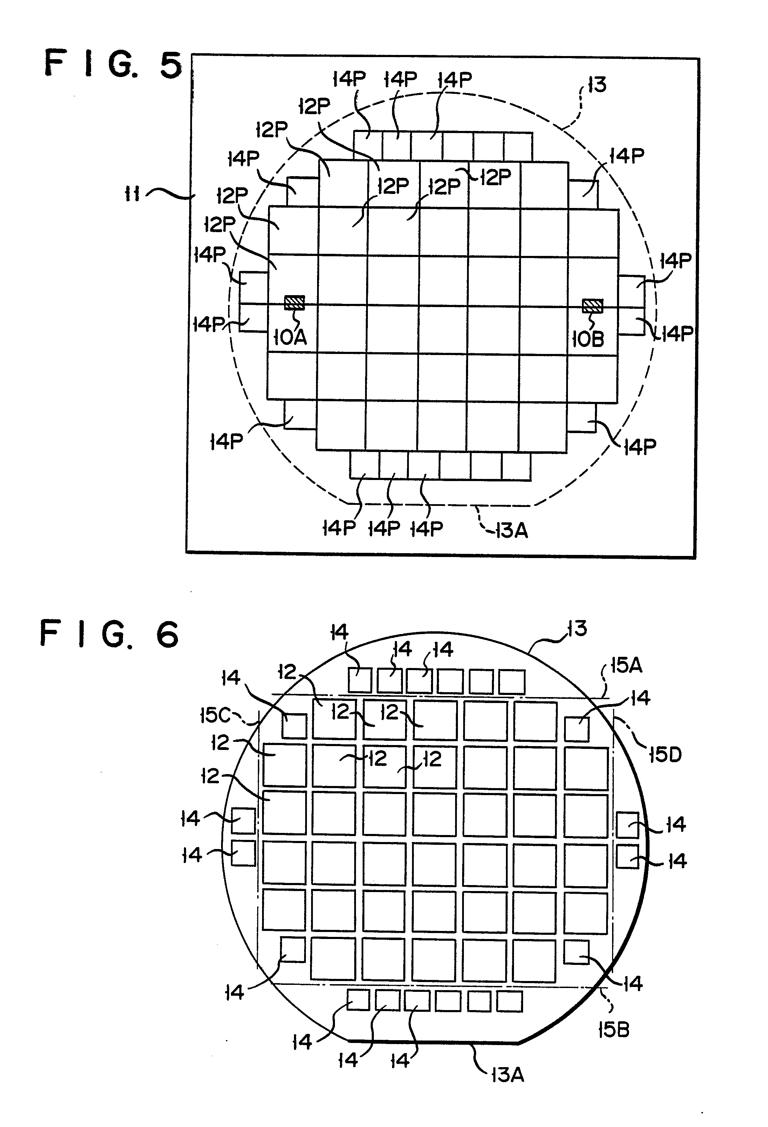

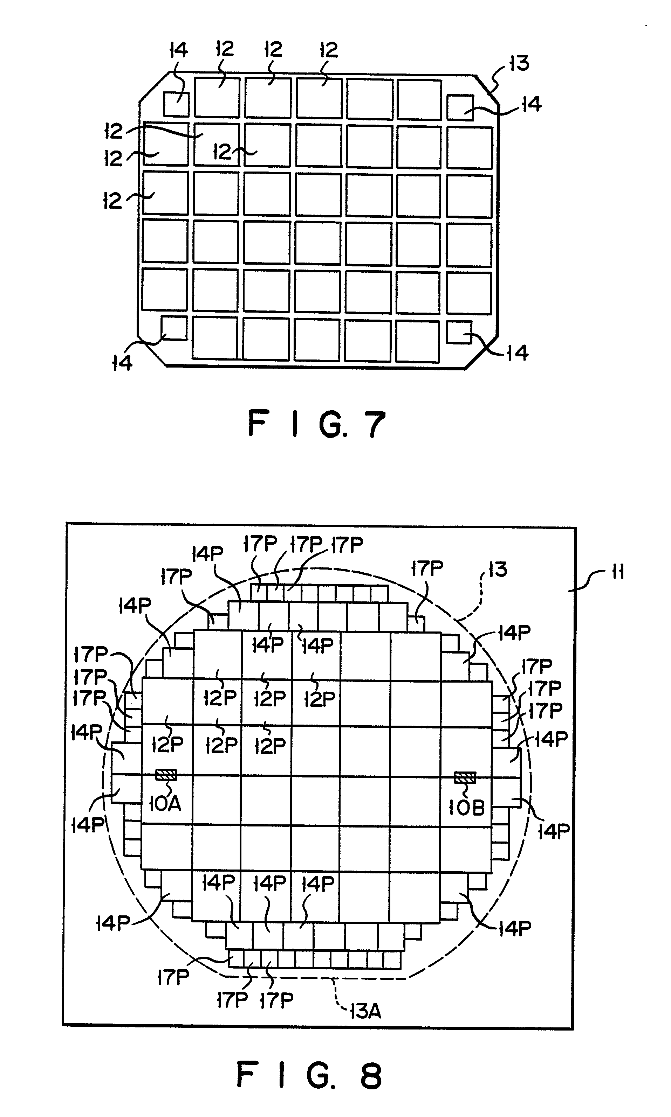

Figs. 5 to 7 are diagrams for illustrating a method for manufacturing a semiconductor device according to another embodiment of this invention, and respectively correspond to Figs. 1 to 3. Parts in Figs. 5 to 7 which correspond to those in Figs. 1 to 3 are denoted by the same reference numerals, and the detail explanation thereof is omitted. In this embodiment, additional small-sized semiconductor pellet patterns 14P are formed in areas corresponding to four corners of large-sized semiconductor pellet patterns 12P. The additional small-sized semiconductor pellet patterns 14P are formed together with large-sized semiconductor pellet patterns 12P in an area surrounded by dicing lines 15A to 15D. The arrangement of semiconductor pellet patterns is advantageous over that in the former embodiment in that the silicon wafer can be more effectively used. In this case, however, when the silicon wafer is diced along dicing lines 15A to 15D, additional small-sized semiconductor pellets 14 are left behind together with large-sized semiconductor pellets 12 in the central area of the silicon wafer as shown in Fig. 7. Therefore, it is necessary to further dice the additional small-sized semiconductor pellets after the dicing process for dicing the central area of the silicon wafer into individual large-sized semiconductor pellets 14 is effected. This makes the dicing process complicated.

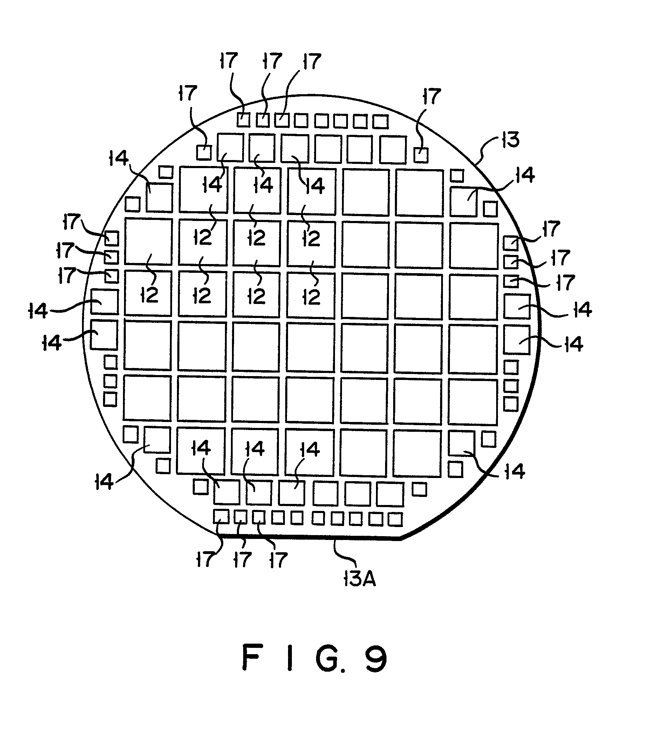

Figs. 8 and 9 are diagrams for illustrating a method for manufacturing a semiconductor device according to still another embodiment of this invention. Parts in Figs. 8 and 9 which correspond to those in Figs. 1 and 2 are denoted by the same reference numerals. In the above embodiments, semiconductor pellets of two different sizes are obtained from a single silicon wafer. However, in this embodiment, semiconductor pellets of three different sizes can be obtained from a single silicon wafer. That is, further small-sized semiconductor pellet patterns 17P which are smaller than small-sized semiconductor pellet patterns 14P are formed in an area between small-sized semiconductor pellet patterns 14P and the periphery of silicon wafer 13. In this embodiment, the silicon wafer can be further effectively used. Also, in this case, it is necessary to arrange the semiconductor pellets so that the silicon wafer can be diced into areas which each include semiconductor pellets, preferably with the same size, using common dicing lines.

It is also possible to form semiconductor pellets with four or more different sizes using a single silicon wafer.

## Claims

1. A method for manufacturing a semiconductor device by forming a plurality of semiconductor pellets in substantially a matrix form and processing the same, characterized by comprising a wafer processing step of arranging a group of large-sized semiconductor pellets (12) in substantially a matrix form in a central area of a semiconductor wafer (13) and a group of small-sized semiconductor pellets (14) in an area between the periphery of said semiconductor wafer (13) and said large-sized semiconductor pellets (12), thus forming different types of semiconductor pellets in said semiconductor wafer (13); and a wafer dicing step of dicing said semiconductor wafer (13) and dividing said semiconductor pellets (12 and 14) from one another for each semiconductor pellet group.

2. A method according to claim 1, characterized in that said wafer dicing step includes a photoetching step using a glass mask (11).

3. A method according to claim 1, characterized in that said dicing step is effected by first dicing said semiconductor wafer (13) to separate said group of large-sized semiconductor pellets (12) from said group of small-sized semiconductor pellets (14), and then dividing said group of large-sized semiconductor pellets (12) into individual large-sized semiconductor pellets (12) and said group of small-sized semiconductor pellets (14) in the peripheral portion of said semiconductor wafer (13) into individual small-sized semiconductor pellets(14).

4. A method according to claim 3, characterized in that said group of small-sized semiconductor pellets (14) are attached to a dicer cutting tape (16) and then divided into individual semiconductor pellets.

5. A method according to claim 1, characterized in that said group of large-sized semiconductor pellets (12) and said group of small-sized semiconductor pellets (14) are so arranged as to be diced by commonly using at least one of dicing lines.

6. A method according to claim 1, characterized in that said wafer processing step includes the same processing step for forming said large-and small-sized semiconductor pellets (14).

7. A method according to claim 1, characterized in that said large-sized semiconductor pellets (12) have large power transistors formed therein and said small-sized semiconductor pellets (14) have small power transistors formed therein.

8. A method according to claim 1, characterized by further comprising a step of performing function test for said semiconductor pellets after said wafer dicing step.

# FIG. 1

# FIG. 2

F I G. 3

F I G. 4

F I G. 5

F I G. 6

F I G. 7

F I G. 8

F I G. 9